# EUROPÄISCHE PATENTSCHRIFT

(11) **EP 2 900 043 B1**
(45) Veröffentlichungstag und Bekanntmachung des Hinweises auf die Patenterteilung: **01.07.2020**
(21) Anmeldenummer: 15405005.8
(22) Anmeldetag: 19.01.2015
(51) Int. Cl.: H05K 5/02, H05K 7/14

(54) **TRAGGEHÄUSE FÜR DIE AUFNAHME VON ELEKTRONIK**
PORTABLE HOUSING FOR HOLDING ELECTRONICS
BOÎTIER-SUPPORT DE LOGEMENT D'ÉLECTRONIQUE

(30) Priorität: 27.01.2014 CH 1062014
(43) Veröffentlichungstag der Anmeldung: 29.07.2015
(73) Patentinhaber: DESA Tech AG, 6300 Zug (CH)
(72) Erfinder: Kummer, Dieter, 8335 Hittnau (CH)
(74) Vertreter: Gachnang, Hans Rudolf

(56) Entgegenhaltungen:
- GB-A- 2 438 900
- KR-A- 20130 079 225
- US-A1- 2010 038 328
- US-B1- 8 413 833

## Beschreibung

Gegenstand der Erfindung ist ein Traggehäuse für die Aufnahme von Elektronik gemäss Oberbegriff des Anspruchs 1.

Elektronische Bauelemente, wie sie für Steuerungen, insbesondere in Fahrzeugen zu Land, in der Luft und auf dem Wasser und im Speziellen in solchen Fahrzeugen für den militärischen Einsatz benötigt werden, sind empfindlich bezüglich mechanischen Schwingungen, hohen Temperaturschwankungen und hohe Feuchtigkeit.

Um diese elektronischen Geräte wie Computer etc. vor unerwünschten mechanischen und atmosphärischen Einflüssen zu schützen, werden diese in sogenannte Traggehäuse eingebaut. Dies sind Gehäuse, die die Einbauten vor Umwelteinflüssen wie extreme Temperaturen, Temperaturschocks, hohe Luftfeuchten, aggressive Atmosphären (z.B. Salznebel auf Schiffen), Sand und Staub in Wüsten oder Industriegebieten, Regen bei Transport zu Land und auf dem Wasser sowie Sonnenbestrahlung und UV-Licht schützen (z.B. US2010/0038328 A1), zusätzlich aber auch vor Vibration, Schock/Schlägen bei freiem Fall (US 8,413,833 B1 und GB 2 438 900). Sie umfassen einerseits ein Gehäuse, das dicht verschliessbar ist und darin einen Schwingungsrahmen, das heisst ein Gestell, welches im Innern des Gehäuses elastisch in X-, Y- und Z-Richtung gedämpft gehalten wird. Im Schwingrahmen werden die Elektronikkomponenten schubladenartig eingeschoben getragen. Mit mindestens einem Deckel, der dicht gegen die klimatische Beanspruchung ist, wird das Gehäuse ein- oder beidseitig geschlossen. Die Traggehäuse können zudem mit einer Klimaanlage ausgerüstet sein, um Temperaturschwankungen im Innern zu vermeiden.

Die bekannten Traggehäuse haben den Nachteil, dass die Schwingrahmen werkseitig, das heisst schon beim Hersteller der Traggehäuse, fest in die Gehäuse eingebaut und dort befestigt werden. Die Elektronikkomponenten können dann nach Entfernen der meistens zwei Deckel aus dem Gehäuse bzw. dem Schwingrahmen ausgebaut und auch wieder eingesetzt werden. Dies bedeutet, dass eine Lieferung von neuen Traggehäusen, oft eine grosse Anzahl von beispielsweise mehreren hundert, erst erfolgen kann, wenn alle Gehäuse-Elemente zusammengefügt sind. Dies bedeutet weiter, dass die gesamte Fabrikation der Gehäuse, das heisst, deren aufwendige Herstellung und anschliessende individuelle Lackierung, vor der Auslieferung zu erfolgen hat. Bei den heute von Kundenseite verlangten kurzen Lieferfristen stellt dies eine hohe Anforderung an die Logistik beim Hersteller dar, und es können zwischen der Unterzeichnung des Kaufvertrags und der Lieferung keine die Lieferzeit nicht verzögernden Änderungswünsche mehr vorgenommen werden.

Im Weiteren sind die Verschlusselemente für die Deckel der bekannten Gehäuse umständlich zu bedienen und werden oft mit zu hohen Drehmomenten angezogen, so dass die Dichtung zwischen Deckel und Gehäuse zerquetscht wird und ein direkter Kontakt zwischen den Metallteilen von Deckel und Gehäuse entsteht. Dies führt zu Undichtigkeit.

Eine Aufgabe der vorliegenden Erfindung besteht nun darin, ein Traggehäuse zu schaffen, welches eine frühzeitige Auslieferung des Schwingungsrahmen an den Kunden ermöglicht, damit dieser den Schwingungsrahmen mit den elektronischen Bauteilen bestücken und diese prüfen kann, und zwar ausserhalb des Gehäuses, so dass letzteres bei der Prüfung der elektronischen Elemente nicht störend wirken kann.

Eine weitere Aufgabe der Erfindung besteht darin, Verschlusselemente am Deckel zu schaffen, welche das Abnehmen und Aufsetzen der Deckel auf einfache Weise ermöglichen und den Deckel in der vorgeschriebenen Weise bezüglich Anpresskraft optimal dichtend am Gehäuse festhalten.

Gelöst wird diese Aufgabe durch ein Traggehäuse mit den Merkmalen des Anspruchs 1. Vorteilhafte Ausgestaltungen der Erfindung sind in den abhängigen Ansprüchen umschrieben.

Es gelingt mit der Ausbildung des erfindungsgemässen Traggehäuses einerseits die Logistik zwischen der Bestellung und der Lieferung der Traggehäuse an die Abnehmer, diesen vorab die einfacher herzustellenden Schwingrahmen für den Einbau der Elektronik und die Prüfung derselben innerhalb der Schwingrahmen zukommen zu lassen und die nach spezifischen Vorschriften gefertigten aufwendigen Gehäuse nachzuliefern. Auch können bei einer Beschädigung eines Gehäuses Ersatzgehäuse nachgeliefert werden, ohne dass das Traggehäuse zusammen mit dem Schwingrahmen ins Werk zurückgeliefert werden muss. Der Schwingrahmen kann zusammen mit der eingebauten Elektronik auf einfache Art und Weise sehr präzise in das Gehäuse eingeschoben und dort fixiert werden. Das Fixieren des Schwingrahmens an der vorgeschriebenen Stelle innerhalb des Gehäuses kann mit einem Inbusschlüssel oder einem gleichartigen Werkzeug erfolgen.

Die für das Einschieben des Schwingrahmens notwendigen gehäuseseitigen Führungsschienen können werkseitig mit höchster Präzision im Gehäuse befestigt und ausgerichtet werden, so dass einerseits das Einschieben der Elektronik einfach und sicher erfolgen kann und andererseits der Schwingrahmen einwandfrei und genau auf den Dämpferelementen befestigt ist.

Der Deckel lässt sich werkzeugfrei auf der Gehäuseöffnung mit der vorgeschriebenen Spannung auf das Dichtrahmenprofil schliessen. Falls erwünscht, können die Verschlusselemente mit einem Schlüssel oder einem verschliessbaren Schloss gegen unberechtigtes Öffnen geschützt werden.

Mit dem erfindungsgemässen Verschlusselement wird der Deckel nach dem Aufsetzen vorerst auf der Gehäuseöffnung zentriert und danach durch Weiterdrehen des Schliesszylinders exakt parallel zur Deckeloberfläche an die Gehäuseöffnung herangeführt und mit vorgebbarer Pressung auf dem Gehäuse festgehalten.

Anhand illustrierter Ausführungsbeispiele wird die Erfindung näher erläutert. Es zeigen:
- Figur 1: eine Explosionsdarstellung eines Traggehäuses, eines Schwingrahmens, des Gehäuserahmens und des Deckels,
- Figur 2: eine perspektivische Darstellung des Verschlusselements in "Schliessstellung",
- Figur 3: eine perspektivische Darstellung des Verschlusselements in "Offenstellung",
- Figur 4: eine Schnittdarstellung einer oberen Gehäuseecke mit Deckel und Verschlusselement,
- Figur 5: eine perspektivische Darstellung einer unteren Gehäusekante von innen gesehen,
- Figur 6: eine perspektivische Ansicht des Gehäuserahmens (linke untere Kante) mit eingesetztem Schwingrahmen,
- Figur 7: eine perspektivische Aufsicht auf die obere Dämpferaufnahme mit einem Spannelement,
- Figur 8: einen Querschnitt durch eine gehäuseseitige Führungsschiene und
- Figur 9: einen Querschnitt durch eine schwingrahmenseitige Führungsschiene.

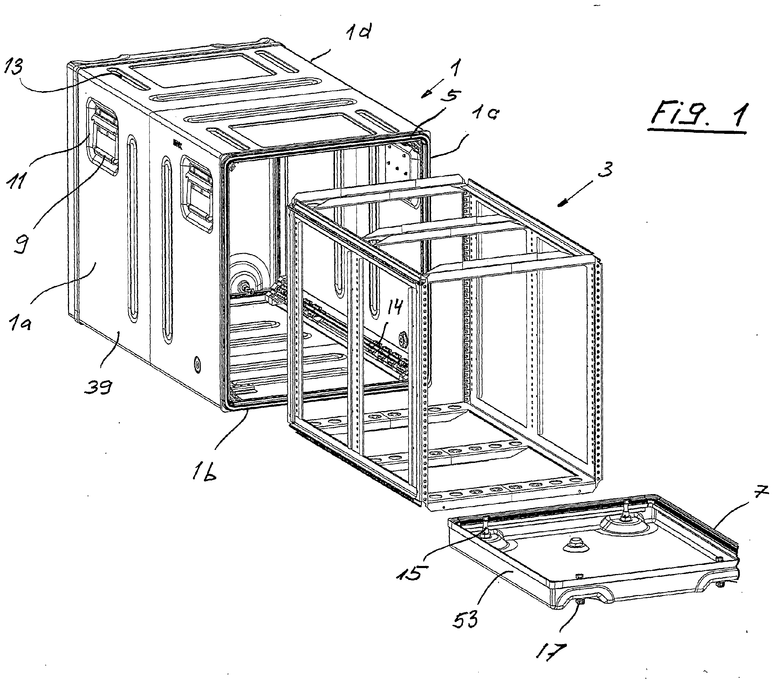

In der Explosions-Darstellung in Figur 1 ist mit Bezugszeichen 1 ein Traggehäuse dargestellt. Vorne ist das Gehäuse 1 offen zum Einschieben eines Schwingrahmens 3, in welchem eine Mehrzahl von Elektronikkomponenten eingeschoben werden kann. Mit Bezugszeichen 5 ist ein Gehäuserahmen bezeichnet, der mit der Vorderseite und auch der Rückseite des Gehäuses 1 verbindbar ausgebildet ist und der Befestigung eines Deckels 7 dient.

Am Gehäuse 1 sind an den Seitenwänden 1a und 1c zum Beispiel Federfallgriffe 9 in geeignet ausgebildeten Mulden 11 sichtbar. Auf der Oberseite 1d des Gehäuses 1 können Stapelvertiefungen 13 ausgebildet bzw. geprägt sein.

An den vier Ecken des Schwingrahmens 3 sind, in einem Winkel von exakt 45° liegende Dämpferelemente 14 angeordnet. Letztere bilden bei in das Gehäuse 1 eingeschobenem Schwingrahmen 3 einerseits Distanzelemente zum Gehäuse 1 und andererseits dämpfen sie auf das Gehäuse 1 einwirkende Schläge, Schwingungen, etc.

Am Deckel 7 sind beispielsweise vier Verschlusselemente 15 ersichtlich, welche mit einem Griff 17 auf der Deckelaussenseite betätigbar sind.

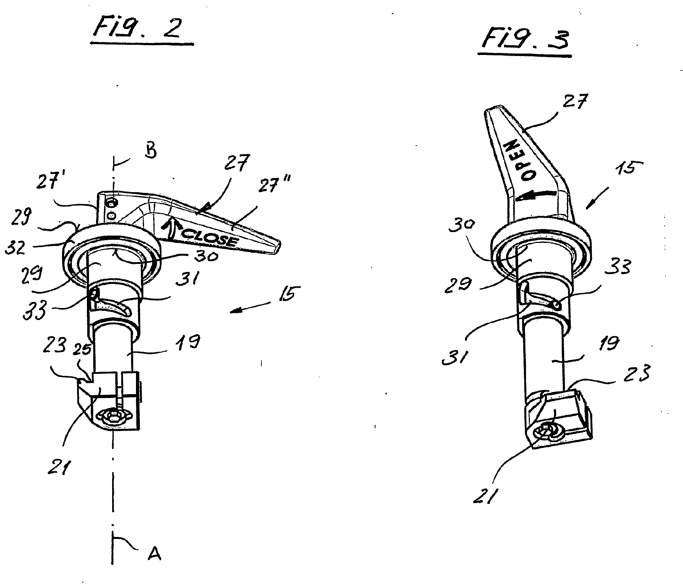

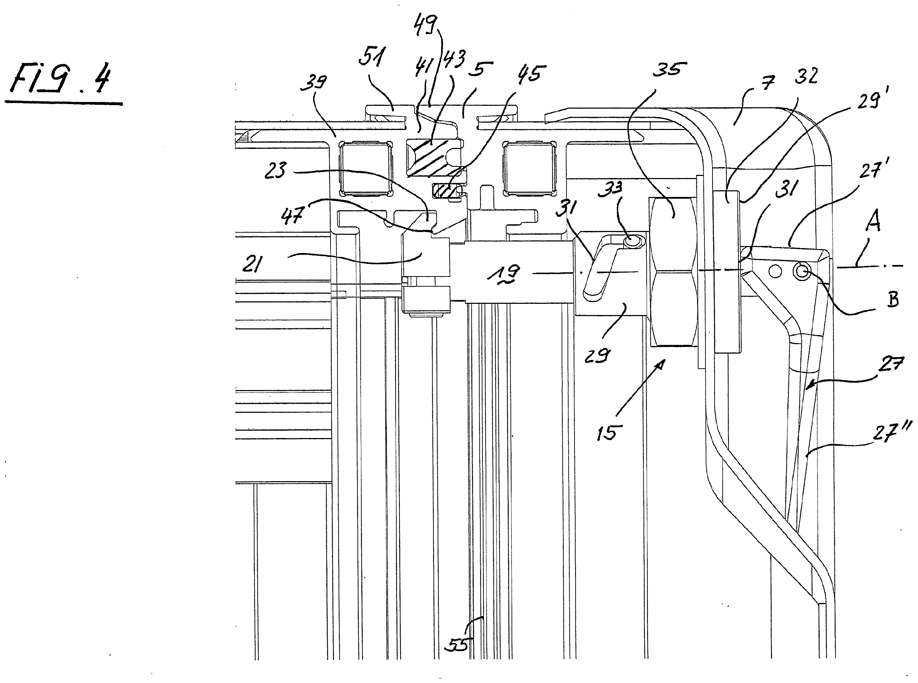

Das Verschlusselement 15, wie es in den Figuren 2 und 3 dargestellt ist, umfasst einen Schliesszylinder 19, an dessen einen Ende ein im Wesentlichen rechtwinklig vom Schliesszylinder 19 abstehender Rückhaltefinger 21 drehfest angebracht ist. Der Rückhaltefinger 21 umfasst, beabstandet zur Mantelfläche des Schliesszylinders 19, eine Rastnase 23, an welcher radial beabstandet zur Vorderkante eine Nut 25 eingelassen ist. Am anderen Ende des Schliesszylinders 19 sitzt ein Spannhebel 27 als Griff, welcher um eine lotrecht zur Dreh-Achse A des Schliesszylinders 19 verlaufende Achse B schwenkbar mit dem Schliesszylinder 19 verbunden, ist. Der zweiarmig ausgebildete Spannhebel 27 weist zwischen dem kürzeren Schenkel 27' und dem längeren Schenkel 27" eine bogenförmig verlaufende Geometrie auf. Der längere Schenkel 27" liegt in der Schiessstellung (gemäss Figur 3) nach dem Überschreiten des Totpunkts rechtswinkelig zur Achse A. In der Schliessstellung (gemäss Figur 3) stützt sich das Ende des kürzeren Schenkels 27' direkt oder indirekt bündig auf der Stirnfläche 29' einer Führungshülse 29 oder einem am oberen Ende der Führungshülse 29 ausgebildeten Bund 32 ab. Anstelle eines Bundes 32 kann auch eine Kontermutter, die auf einem Gewinde 30 kämmt, treten. Die Führungshülse 29 dient als Drehlager und axialer Anschlag für den Schliesszylinder 19 und umschliesst letzteren über eine Teillänge. In der Führungshülse 29 ist eine Führungskurve 31 eingelassen, in welche ein radial von der zylindrischen Oberfläche des Schliesszylinders 19 abstehender Führungsbolzen 33 eingreift. Am oberen Ende der Führungshülse 29 ist das Gewinde 30 ausgebildet, auf welchem eine Schraubenmutter 35 sitzt, mit welcher das Verschlusselement 15 in einer Bohrung im Deckel 7 zusammen mit einer (nicht sichtbaren) Kontermutter gehalten wird. Anstelle einer Kontermutter kann auch der fest mit der Führungshülse 29 verbundene oder an dieser angebrachte Bund 32 treten (vergl. Fig. 4).

Um eine Verbindung zwischen dem im Deckel 7 befestigten Verschlusselement 15 mit dem Gehäuse 1 herzustellen, ist auf der Öffnung des Gehäuses 1 der Gehäuserahmen 5 aufgesetzt und mit dem Mantel 39 des Gehäuses 1 durch geeignete Verbindungsmittel unlösbar verbunden. Der Gehäuserahmen 5 umfasst ein gezogenes Aluminiumprofil 41, welches die elastischen Dichtungselemente 43 und 45 trägt, und an welchem im Bereich seines Innenumfangs eine vom Deckel 7 weggerichtete Haltenut 47 ausgebildet ist. Die Haltenut 47 kann vollständig an der Gehäuseöffnung umlaufend ausgebildet sein oder nur im Bereich, wo die Verschlusselemente 15 am Gehäuserahmen 5 angreifen (Figur 4) .

Nachfolgend wird die Funktionsweise des Verschlusselements 15 erläutert. Nach dem Einbau der elektronischen Komponenten (nicht dargestellt) in den Schwingrahmen 3, wird der Deckel 7 auf den Gehäuserahmen 5 aufgeschoben. Die Zentrierung des Deckels 7 erfolgt durch einen am Deckel 7 umlaufenden Steg 49, welcher über einen umlaufenden Kragen 51 am Gehäuserahmen 5 geschoben wird. Der Steg 49 kann Teil des Deckels 7 sein oder Teil eines mit dem Deckel 7 verbundenen Deckelrahmens 53, welcher vorzugsweise aus einem Aluminiumprofil 55 besteht. Die Profilierung der stirnseitigen Fläche des Deckelrahmens 53 ist auf die stirnseitige Fläche des Gehäuserahmens 5 abgestimmt und bildet mit letzterem bei eingesetztem Deckel 7 eine dichte druckfeste und formschlüssige Verbindung, sobald die Verschlusselement 15 in Schliessstellung gebracht worden sind. Beim Aufsetzen des Deckels 7 greifen die mindestens vier am Deckel 7 angebrachten Verschlusselemente 15 in die Gehäuseöffnung ein und deren Schliesszylinder 19 liegt dann mit geringem Abstand zu der Haltenut 47 am Gehäuserahmen 5. Durch einen Druck auf den Verschlusshebel 27 und eine Schwenkbewegung des Verschlusshebels 27 aus der im Wesentlichen parallel zur Achse A liegenden Position von dessen längerem Schenkel 27" in eine rechtwinklig zur Achse A liegende Stellung wird, ausgelöst durch die Führungskurve 31 an der Führungshülse 29 der Schliesszylinder 19 zusammen mit dem Spannhebel 27 um ca. 90° gedreht und dadurch die Rastnase 23 am Schliesszylinder 19 über die Haltenut 47 am Gehäuserahmen 5 geführt. Sobald die Schwenkbewegung des Schliesszylinders 19 beendet ist, wird dieser durch die weitere Schwenkung des Spannhebels 27 axial nach oben in Richtung Spannhebel 27 gezogen. Dabei greift die Rastnase 23 in die Haltenut 47 am Gehäuserahmen 5 ein. Am Ende der Schwenkbewegung des Spannhebels 27 ist der Deckel 7 an den Gehäuserahmen 5 herangeführt worden und die Dichtelemente 43 und 45 sind optimal zusammengepresst. Die linearen Verläufe einerseits der Haltenut 47 am Gehäuserahmen 5 und andererseits der Nut 25 an der Rastnase 23 stellen sicher, dass keine Drehung des Schliesszylinders 19 erfolgen kann, ohne dass der Spannhebel 27 aktiv über dem Totpunkt zurück in die vertikale geschwenkt wird. Der Deckel 7 ist somit erschütterungssicher mit dem Gehäuse 1 verbunden.

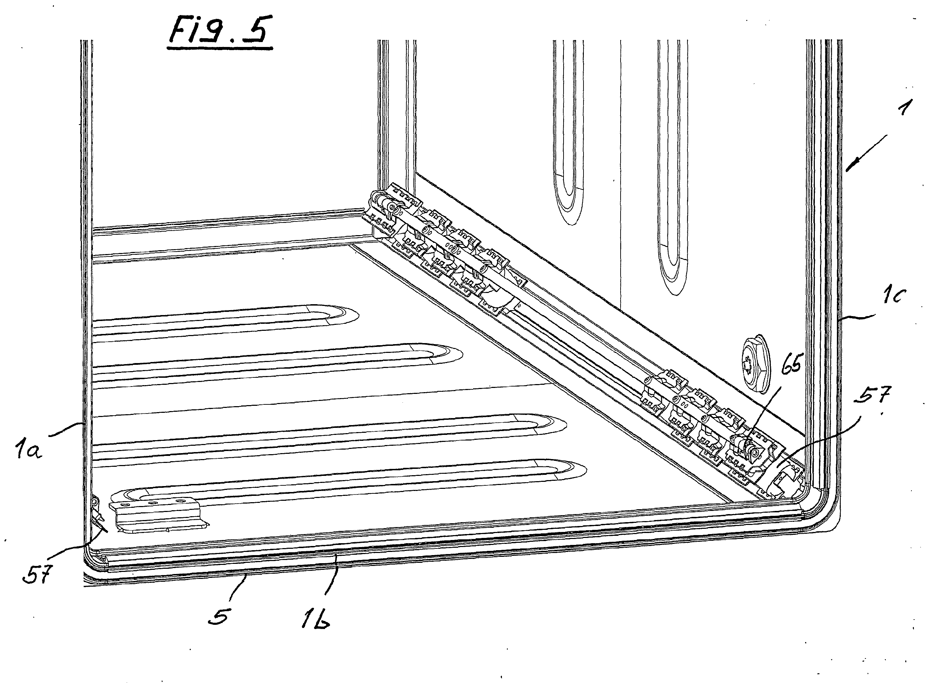

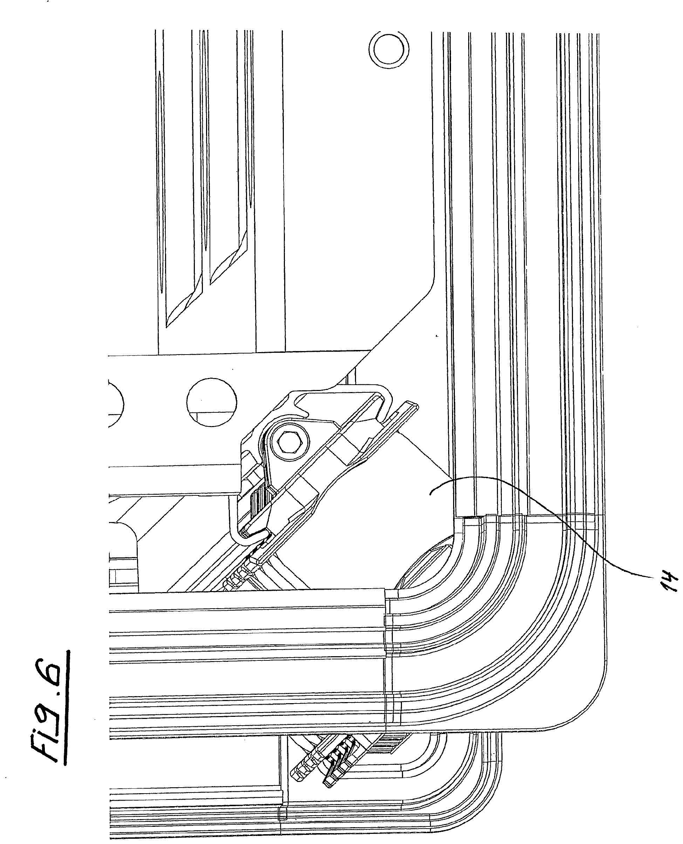

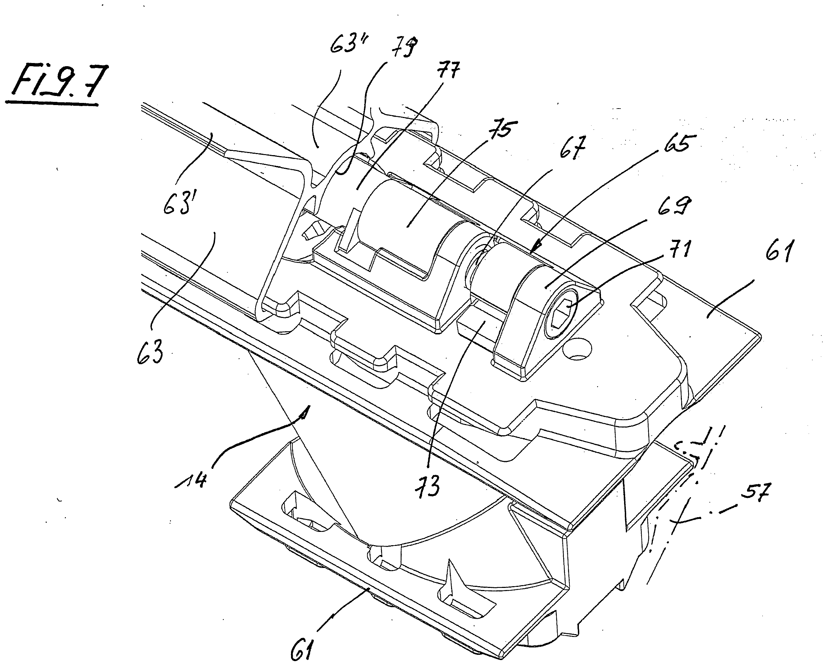

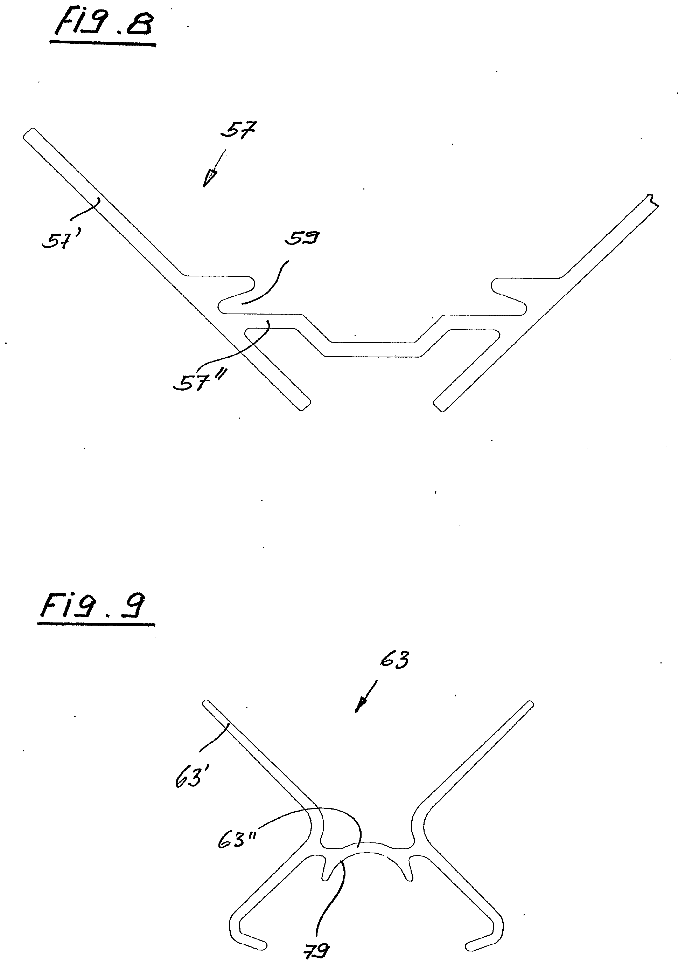

Die Anzahl der Verschlusselemente 15 richtet sich nach der Grösse des Gehäuses 1. Bei einem einfachen kleinen Gehäuse, wie in Figur 1 dargestellt, genügen vier Verschlusselemente 15; grössere Gehäuse 1 benötigen eine entsprechend grössere Anzahl von Verschlusselementen 15. In den Figuren 5 bis 9 wird der Aufbau der Verbindung zwischen dem Gehäuse 1 und dem Schwingrahmen 3 näher erläutert. Am Gehäuse 1 ist eine erste Führungsschiene 57 im Bereich der Verbindung der Seitenwände 1a/1b, 1b/1c, 1c/1d und 1d/1a dargestellt. In Figur 5 ist in vergrösserter Darstellung die Seitenkante zwischen den Seitenwänden 1b/1c ersichtlich. Im Vordergrund umgibt der Gehäuserahmen 5 entlang der Gehäuseöffnung die vier Seitenwände 1a-1d. Im Übergangsbereich der jeweiligen Seitenflächen ist auf der Gehäuseinnenseite jeweils eine erste Führungsschiene 57 eingelegt. Deren in einem Winkel von 90° liegende Schenkel 57' sind mit jeweils zwei aneinander stossenden Gehäuseseitenflächen verbunden. Die Verbindung kann durch Kleben, Schweissen oder andere widerstandsfähige Verbindungsmittel erfolgen (Figur 8). Die beiden Schenkel 57', der im Querschnitt V-förmige ausgebildeten ersten Führungsschiene 57 sind durch einen im Wesentlichen horizontalen Verbindungssteg 57" verbunden. Oberhalb dieses Verbindungsstegs 57" ist beidseitig je eine Nut 59 ausgebildet, in welche Dämpferaufnahmen 61 der Dämpferelemente 14 einschiebbar sind.

Analog zu den ersten Führungsschienen 57 am Gehäuse 1 sind am Schwingrahmen 3 zweite Führungsschienen 63 angeordnet. Die zweiten Führungsschienen 63 können die Längskanten des Schwingrahmens 3 bilden, das heisst die beiden Seitenflächen des Schwingrahmens 3, zum Beispiel gelochte Platten, sind an Schenkeln 63', die V-förmig verlaufend in einem 90° Winkel angeordnet sind, befestigt. Die im Querschnitt X-förmige zweite Führungsschiene 63 umfasst ebenfalls einen die beiden Schenkel 63' verbindenden Brückenteil 63". Unterhalb des Brückenteils 63" ist eine Führung für die Dämpferaufnahmen 61 des Dämpferelements 14 ausgeformt. In diese Führung können die Dämpferaufnahmen 61 des Dämpferelements 14 eingeschoben und darin arretiert werden (Figur 9).

Die beiden Dämpferaufnahmen 61 am Dämpferelement 14 sind derart ausgebildet, dass sie jeweils mit den beiden Führungsschienen 57 und 63 einschiebbar mit diesen verbindbar sind. Die Dämpferaufnahme 61, welche mit der ersten Führungsschiene 57 eingeschoben wird, kann auf eine nicht näher bezeichnete Weise mit der Führungsschiene 57 verbunden werden. Die zweite Führungsschiene 63, welche am Schwingrahmen 3 befestigt ist, umfasst ein Verriegelungselement 65. Das Verriegelungselement 65 umfasst eine Verriegelungswelle 67, welche in mindestens einen Lagerbock 69 drehbar gelagert ist. Der Lagerbock 69 ist fest mit der Oberseite der Dämpferaufnahme 61 verbunden oder kann Teil von diesem sein. Die Verriegelungswelle 67 weist stirnseitig eine Sechskantbohrung 71 auf, in welche ein Inbusschlüssel einsteckbar ist, um die Verriegelungswelle 67 zu drehen. Selbstverständlich kann anstelle einer Sechskantbohrung 71 auch eine andere mit einem Drehwerkzeug verbindbare Ausbildung gewählt werden.

Hinter dem Lagerbock 69 ist an der Verriegelungswelle 67 ein radial von dieser abstehender Bart 73, analog einem Schlüsselbart, ausgebildet. Axial anschliessend an den Bart 73 ist auf der Welle ein Gummirohr 75 aufgeschoben. Wiederum axial anschliessend sitzt auf der Verriegelungswelle 67, die dort als Gewinde ausgebildet ist, eine mit einem Innengewinde versehene Presshülse 77. Die Presshülse 77 dient dazu, dass bei einer Drehung der Verriegelungswelle 67 die Presshülse 77 axial gestaucht und dadurch deren Durchmesser vergrössert wird.

An der zweiten Führungsschiene 63 ist an der Verbindungsbrücke 63" ein gegen die Dämpferaufnahme 61 gerichteter konkaver Bereich 79 ausgebildet. Beim Einschieben der Dämpferaufnahmen 61 in die zweite Führungsschiene 63 liegt die Oberfläche des Gummirohrs 75 in geringem Abstand von der konkaven Fläche 79. Wird nun nach dem Einschieben des Schwingrahmens 3 in das Gehäuse 1 die Verriegelungswelle 67 mit einem geeigneten Drehwerkzeug um 90° gedreht, so wird einerseits das Gummirohr 75 gestaucht und damit im Durchmesser vergrössert. Durch die Vergrösserung des Durchmessers des Gummirohrs 75 kommt dieses in Anlage mit der konkaven Fläche 79. Gleichzeitig gelangt auch der Bart 73 in Anlage mit dem konkaven Bereich 79. Die Dämpferaufnahme 61 ist nun im reibschlüssigen Kontakt mit der zweiten Führungsschiene 63. Diese lässt sich axial nicht mehr verschieben. Dies bedeutet, dass der Schwingrahmen 3 unverschiebbar und somit reib- und formschlüssig im Gehäuse 1 gehalten wird. Der Schwingrahmen 3 kann folglich durch eine Viertelsdrehung der Verriegelungswellen 67 an den vier Seitenkanten des Schwingrahmens 3 ohne weiteres als Gesamtes aus dem Gehäuse 1 herausgezogen und wieder in dieses hineingeschoben werden. Die Verriegelungswellen 67 können einseitig oder bei einem Gehäuse 1 mit zwei Deckeln 7 vorzugsweise beidseitig angeordnet werden. Diese Ausführung ermöglicht es folglich zur Wartung eines einzelnen oder mehrerer Elektronik-Einbauten, diese entweder einzeln aus dem Schwingrahmen 3 herauszuziehen oder den gesamten Schwingrahmen 3 aus dem Gehäuse 1 herauszulösen und dann die notwendigen Wartungs- oder Prüfungsarbeiten vorzunehmen.

Selbstverständlich lässt sich die beschriebene Ausführung einer Verbindung zwischen Schwingrahmen 3 und dem Gehäuse 1 auch in Gehäusen mit anderen Deckelverschlüssen einsetzen.

**Legende der Bezugszeichen**

| | | | |
|---|---|---|---|
| 1 | Gehäuse | 61 | Dämpferaufnahme |
| 3 | Schwingrahmen | 63 | Zweite Führungsschiene |
| 5 | Gehäuserahmen | 63' | Schenkel |
| 7 | Deckel | 63" | Brückenteil |
| 9 | Federfallgriffe | 65 | Verriegelungselement |
| 11 | Mulden für 9 | 67 | Verriegelungswelle |
| 13 | Stapelvertiefung | 69 | Lagerbock |
| 14 | Dämpferelemente | 71 | Sechskantbohrung |
| 15 | Verschlusselemente | 73 | Bart |
| 17 | Griff | 75 | Gummirohr |
| 19 | Schliesszylinder | 77 | Presshülse |
| | | 79 | konkaver Bereich |
| 21 | Rückhaltefinger | | |
| 23 | Rastnase | | |
| 25 | Nut | | |
| 27 | (Spann-)Hebel | | |
| 27' | kürzerer Schenkel | | |
| 27" | längerer Schenkel | | |
| 29 | Führungshülse | | |
| 29' | Stirnfläche | | |
| 30 | Gewinde | | |
| 31 | Führungskurve | | |
| 32 | Bund | | |
| 33 | Führungsbolzen | | |
| 35 | Schraubenmutter | | |
| 39 | Mantel von 1 | | |
| 41 | Aluminiumprofil | | |
| 43 | Dichtungselemente | | |
| 45 | Dichtungselemente | | |
| 47 | Haltenut | | |
| 49 | Steg | | |
| 51 | Kragen | | |
| 53 | Deckelrahmen | | |
| 55 | Aluminiumprofil | | |
| 57 | erste Führungsschiene | | |
| 57' | Schenkel | | |
| 57" | horizontaler Verbindungssteg | | |
| 59 | zweite Nut | | |

## Patentansprüche

1. Traggehäuse für die Aufnahme von Racks mit elektronischen Komponenten für den zivilen und militärischen Einsatz zu Land, zu Wasser und in der Luft, insbesondere zur Verwendung unter schwierigen Verhältnissen durch extreme Temperaturen, Schläge und Beschleunigungen sowie hohe Feuchtigkeit, umfassend einen Gehäusemantel, mindestens einen abnehmbaren Deckel (7) zum Verschliessen der mindestens einen Gehäuseöffnung und einen im Gehäuse (1) elastisch gelagerten Schwingrahmen (3) zur Aufnahme von Elektronikkomponenten, wobei der mindestens eine Deckel (7) auf einen Rahmen (5), der die Gehäuseöffnung umschliesst und mit dem Mantel des Gehäuses 1 verbunden ist, aufsetzbar ausgebildet ist, und der Rahmen (5) mindestens ein umlaufendes Dichtungsprofil (43, 45) und einen umlaufenden hinterschnittenen Steg (49) und eine vom Deckel (7) weggerichtete umlaufende Haltenut (47) umfasst, welche dem Eingriff eines Verschlusselements (15) dient und das Verschlusselement (15) eine im Deckel (7) drehfest anbringbare Führungshülse (29) und einen darin drehbar gelagerten Schliesszylinder (19) umfasst, an dessen einen Ende ein radial vom Schliesszylinder (19) abstehender Rückhaltefinger (21) angeordnet ist und an dessen deckelseitig aussen zu liegen kommenden anderen Ende ein auf einer lotrecht zur Achse A des Schliesszylinders (19) schwenkbar gelagerter Spannhebel (27) mit einem längeren Schenkel (27") und einem kürzeren Schenkel (27') aufgesetzt ist, mit welchem der Schliesszylinder (19) axial zum Deckel (7) hin in der Führungshülse (29) verschieb- und feststellbar ist,
**wobei** am Schliesszylinder (19) ein radial nach aussen ragender Führungsbolzen (33) befestigt ist,
**wobei** der Führungsbolzen (33) in eine schraubenlinienförmig verlaufende Führungskurve (31) an der Führungshülse (29) eingreift und
**wobei** die Führungskurve (31) derart verläuft, dass bei Schwenken des Spannhebels (27) aus der parallel zur Achse A liegenden Position des längeren Schenkels (27") in eine im Wesentlichen rechtwinklige Position zu Achse A ausgelöst durch die Führungskurve (31), der Schliesszylinder (19) zusammen mit dem Spannhebel (27) um ca. 90° gedreht und dadurch eine sich am Rückhaltefinger (21) befindende zur Mantelfläche des Schliesszylinders (19) beabstandete Rastnase (23) über die Haltenut (47) am Gehäuserahmen geführt wird,
wobei auf der Innenseite des Gehäusemantels im Bereich der Verbindungsstellen der vier Seitenflächen (1a-1d) erste Führungsschienen (57) und an den der vier Seitenkanten des Schwingrahmens (3), welche parallel zu den Verbindungsstellen der Seitenflächen (1a-1d) des Mantels des Gehäuses (1) liegen, zweite Führungsschienen (63) ausgebildet sind, wobei zwischen der ersten und zweiten Führungsschiene (57, 63) Dämpferelemente (14) eingesetzt sind, welche den Schwingrahmen (3) elastisch federnd im Gehäuse (1) tragen,
**dadurch gekennzeichnet, dass**
die Dämpferelemente (14) zwischen zwei in den beiden Führungsschienen (57, 63) verschiebbare Dämpferaufnahmen (61) eingesetzt und mit diesen verbunden sind, dass an mindestens einer Dämpferaufnahme (61) ein Mittel zum Arretieren und Fixieren der Dämpferaufnahme (61) in der Führungsschiene (63) ausgebildet ist.

2. Traggehäuse nach Anspruch 1, **dadurch gekennzeichnet, dass** die Führungskurve (31) einen ersten schraubenlinienförmig verlaufenden Abschnitt zur Erzeugung der Drehbewegung des Schliesszylinders (19) und anschliessend einen zur Achse des Schliesszylinders (19) parallelen Abschnitt zur Erzeugung einer axialen Bewegung des Schliesszylinders (19) umfasst.

3. Traggehäuse nach Anspruch 2, **dadurch gekennzeichnet, dass** der achsparallele Abschnitt der Führungskurve (31) eine Drehung des Schliesszylinders (19) in der Schliessstellung verhindert.

4. Traggehäuse nach Anspruch 3, **dadurch gekennzeichnet, dass** als Mittel zum Fixieren ein radial expandierbares, eine Reibkraft auf die Führungsschiene (63) ausübendes Gummielement (75) umfasst.

5. Traggehäuse nach Anspruch 4, **dadurch gekennzeichnet, dass** das Gummielement (75) durch eine diese durchdringende Verriegelungswelle (67) axial zusammenpress- und dadurch radial expandierbar ist.

6. Traggehäuse nach Anspruch 5, **dadurch gekennzeichnet, dass** die Verriegelungswelle (67) zum Fixieren der Dämpferaufnahme (61) in der Führungsschiene (63) stirnseitig mit einem Schraubendreher oder Schraubenschlüssel drehbar ist.

7. Traggehäuse nach einem der Ansprüche 5 oder 6, **dadurch gekennzeichnet, dass** zusätzlich zum Gummielement (75) ein auf der Verriegelungswelle (67) befestigter Arretierbart (73) zum Fixieren der Dämpferaufnahme (61) in der Führungsschiene (63) ausgebildet ist.

## Claims

1. A portable housing for holding racks having electronic components for civil and military deployment on land, at sea and in the air, in particular for use in difficult conditions caused by extreme temperatures, impacts and accelerations as well as high humidity, comprising a housing shell, at least one removable cover (7) for closing the at least one housing opening and a swing frame (3) for holding electronic components elastically supported in the housing (1), wherein the at least one cover (7) is configured such that it is mountable on a frame (5) which encloses the housing opening and is connected to the shell of the housing 1, and the frame (5) comprises at least one circumferential sealing profile (43, 45) and a circumferential undercut crosspiece (49) and a circumferential holding groove (47) which is directed away from the cover (7), which serves to engage a closure element (15) and the closure element (15) comprises a guide sleeve (29) which can be installed in a non-rotational manner in the cover (7) and a lock cylinder (19) rotatably supported therein, at the one end of which a retaining finger (21) projecting radially from the lock cylinder (19) is arranged and at the other end of which, said end lying externally on the cover side, a clamping lever (27) having a longer leg (27") and a shorter leg (27') is mounted, which is swivelably supported perpendicularly to the axis A of the lock cylinder (19), with which clamping lever the lock cylinder (19) is displaceable and fixable axially towards the cover (7) in the guide sleeve (29),
wherein a radially outwardly protruding guide bolt (33) is fastened to the lock cylinder (19),
wherein the guide bolt (33) engages in a guide cam (31) running helically on the guide sleeve (29), and
wherein the guide cam (31) runs in such a manner that when the clamping lever (27) is swung out of the position of the longer leg (27") lying parallel to the axis A into a position which is substantially at right angles to axis A, triggered by the guide cam (31), the lock cylinder (19) is rotated together with the clamping lever (27) by approx. 90° and, as a result, a detent (23) located on the retaining finger (21) at a distance from the shell surface of the lock cylinder (19) is guided by means of the holding groove (47) on the housing frame,
wherein first guide rails (57) are configured on the inner side of the housing shell in the region of the connecting points of the four side surfaces (la-1d) and second guide rails (63) are configured on the four side edges of the swing frame (3) which are located parallel to the connecting points of the side surfaces (la-1d) of the shell of the housing (1), wherein damper elements (14) are deployed between the first and second guide rail (57, 63), which damper elements carry the swing frame (3) in an elastically resilient manner in the housing (1),
**characterized in that**
the damper elements (14) are deployed between two displaceable damper receptacles (61) in the two guide rails (57, 63) and are connected to these, **in that** a means for locking and fixing the damper receptacle (61) in the guide rail (63) is configured on at least one damper receptacle (61).

2. The portable housing according to Claim 1, **characterized in that** the guide cam (31) comprises a first portion running helically in order to produce the rotating movement of the lock cylinder (19) and, subsequently, a portion for producing an axial movement of the lock cylinder (19) parallel to the axis of the lock cylinder (19).

3. The portable housing according to Claim 2, **characterized in that**
the axially parallel portion of the guide cam (31) prevents a rotation of the lock cylinder (19) in the closed position.

4. The portable housing according to Claim 3, **characterized in that**
said portable housing comprises, as means for fixing, a radially expandable rubber element (75) exerting a friction force on the guide rail (63).

5. The portable housing according to Claim 4, **characterized in that**
the rubber element (75) can be axially compressed and, as a result, can be radially expanded by a locking shaft (67) penetrating the latter.

6. The portable housing according to Claim 5, **characterized in that**
the locking shaft (67) for fixing the damper receptacle (61) in the guide rail (63) can be rotated on the front side with a screwdriver or wrench.

7. The portable housing according to any one of Claims 5 or 6, **characterized in that**,
in addition to the rubber element (75), a locking bit (73) fastened on the locking shaft (67) is configured for fixing the damper receptacle (61) in the guide rail (63).

## Revendications

1. Boîtier support de logement de bâtis avec composants électroniques pour l'utilisation civile et militaire sur terre, sur l'eau et dans les airs, en particulier utilisation en conditions difficiles du fait de températures extrêmes, de chocs et d'accélérations ainsi que d'une humidité élevée, comprenant une enveloppe de boîtier, au moins un couvercle amovible (7) pour la fermeture de l'au moins une ouverture de boîtier et un châssis oscillant (3) monté de façon élastique dans le boîtier (1) pour l'accueil de composants électroniques, l'au moins un couvercle (7) étant formé pour pouvoir être placé sur un châssis (5), lequel entoure l'ouverture de boîtier et est relié avec l'enveloppe du boîtier 1, et le châssis (5) comprenant au moins un profil d'étanchéité circonférentiel (43, 45) et un montant en contre-dépouille circonférentiel (49) et une rainure de maintien circonférentielle (47) orientée vers le côté opposé au couvercle (7), laquelle sert à la prise d'un élément de fermeture (15), et l'élément de fermeture (15) comprenant une douille de guidage pouvant être placée de façon solidaire en rotation dans le couvercle (7) et un cylindre de fermeture (19) monté de façon pivotante dans celle-ci, à l'extrémité duquel un doigt de retenue (21) faisant saillie radialement par rapport au cylindre de fermeture (19) est disposé, et à l'autre extrémité duquel, venant s'appliquer à l'extérieur du côté du couvercle, un levier de serrage étant monté de façon pivotante perpendiculairement à l'axe A du cylindre de fermeture (19) avec un bras long (27") et un bras court (27') est placé, avec lequel le cylindre de fermeture (19) est déplaçable et bloquable axialement par rapport au couvercle (7) dans la douille de guidage (29),
une broche guide (33) dépassant radialement vers l'extérieur étant fixée sur le cylindre de fermeture (19),
la broche guide (33) s'engageant dans une courbe de guidage (31) s'étendant de façon hélicoïdale sur la rainure de guidage (29) et
la courbe de guidage (31) s'étendant de telle sorte que le cylindre de fermeture (19) est pivoté conjointement avec le levier de serrage (27) d'environ 90° et que par cela, un bec d'encliquetage (23) se trouvant sur le doigt de retenue (21) à distance de la surface d'enveloppe du cylindre de fermeture (19) est mené par la rainure de maintien (47) sur le châssis de boîtier, lors du basculement du levier de serrage (27) de la position du bras long (27") étant parallèle à l'axe A à une position essentiellement perpendiculaire à l'axe A, déclenché par la courbe de guidage (31),
des premiers rails de guidage (57) sur le côté intérieur de l'enveloppe de boîtier dans la zone des emplacements de liaison des quatre surfaces latérales (la-ld) et, sur les quatre bords latéraux du châssis oscillant (3), lesquels sont parallèles aux emplacements de liaison des surfaces latérales (la-ld) de l'enveloppe du boîtier (1), des deuxièmes rails de guidage (63) étant formés, des éléments amortisseurs (14) étant placés entre le premier et le deuxième rails de guidage (57, 63), lesquels éléments portent le châssis oscillant (3) de façon élastique dans le boîtier,
**caractérisé en ce que**
les éléments amortisseurs (14) sont placés entre deux logements d'amortisseurs (61) déplaçables dans les deux rails de guidage (57, 63) et sont reliés avec ceux-ci, **en ce qu'**un moyen pour le blocage et la fixation du logement d'amortisseur (61) dans le rail de guidage (63) est formé sur au moins un logement d'amortisseur (61).

2. Boîtier support selon la revendication 1, **caractérisé en ce que** la courbe de guidage (31) comprend une première section s'étendant de façon hélicoïdale pour la génération du mouvement de rotation du cylindre de fermeture (19) et, de façon adjacente, une section parallèle à l'axe du cylindre de fermeture (19) pour la génération d'un mouvement axial du cylindre de fermeture (19).

3. Boîtier support selon la revendication 2, **caractérisé en ce que**
la section de la courbe de guidage (31) parallèle à l'axe empêche une rotation du cylindre de fermeture (19) dans la position de fermeture.

4. Boîtier support selon la revendication 3, **caractérisé en ce que**,
le boitier support comprend un élément en caoutchouc (75) expansible radialement, exerçant une force de friction sur le rail de guidage (63) comme moyen de fixation.

5. Boîtier support selon la revendication 4, **caractérisé en ce que**
l'élément en caoutchouc (75) est comprimable axialement par un axe de verrouillage (67) traversant celui-ci et ainsi expansible radialement.

6. Boîtier support selon la revendication 5, **caractérisé en ce que**
l'arbre de verrouillage (67) peut être pivoté du côté frontal avec un tournevis ou une clé de serrage, pour la fixation du logement d'amortisseur (61) dans le rail de guidage (63).

7. Boîtier support selon l'une quelconque des revendications 5 ou 6, **caractérisé en ce qu'**
une barbe de blocage (73) fixée sur l'arbre de verrouillage (67) est formée pour la fixation du logement d'amortisseur (61) dans le rail de guidage (63), en plus de l'élément en caoutchouc (75).
